# DEMANDE DE BREVET EUROPEEN

(11) **EP 0 710 061 A1**
(43) Date de publication de la demande: **01.05.1996**
(21) Numéro de dépôt: 95402343.8
(22) Date de dépôt: 20.10.1995
(51) Int. Cl.: H05K 3/28

(54) **Procédé et dispositif de protection hermétique de circuit électronique**

(30) Priorité: 25.10.1994 FR 9412726
(71) Demandeur: COMPAGNIE EUROPEENNE DE COMPOSANTS ELECTRONIQUES LCC, F-21850 St. Apollinaire (FR)
(72) Inventeur: Stephan, Ronan, F-92402 Courbevoie Cédex (FR); Val, Christian, F-92402 Courbevoie Cédex (FR)
(74) Mandataire: Benoit, Monique

(57) **Abrégé**

La présente invention a pour objet l'encapsulation de circuits électroniques, encapsulation qui soit hermétique c'est-à-dire qui ne laisse pas passer les gaz et, tout particulièrement, pas la vapeur d'eau.

Selon l'invention, cette encapsulation est réalisée par une couche (13) dont la composition est variable; cette couche est constituée d'un matériau électriquement isolant du côté du circuit imprimé, dont la composition varie avec l'épaisseur de la couche entre matériau organique et matériau minéral, le matériau minéral formant une pellicule hermétique.

## Description

La présente invention a pour objet l'encapsulation de circuits électroniques, encapsulation qui soit hermétique c'est-à-dire qui ne laisse pas passer les gaz et, tout particulièrement, pas la vapeur d'eau.

En effet, ainsi qu'il est connu, le problème de la suppression ou, à défaut, de la limitation de l'humidité dans l'atmosphère entourant les composants électroniques est un problème aigu.

On sait que le contaminant ayant le rôle le plus important et le plus néfaste sur le plan de la fiabilité d'un composant discret ou d'un circuit intégré est la teneur en eau de l'ambiance environnante. En effet, l'humidité est notamment susceptible de corroder les plots de connexion des circuits; elle permet également aux ions de se solubiliser, ce qui renforce la corrosion. Ces effets sont très sensibles sur les circuits intégrés et, ce, d'autant plus que le degré d'intégration est plus élevé, c'est-à-dire que les plots de connexion sont plus petits.

Pour protéger hermétiquement les circuits électroniques, différentes solutions sont connues parmi lesquelles on peut citer la demande de brevet français n° 90.10631 déposée le 24 Août 1990 au nom de THOMSON-CSF. Selon cette solution, on dépose sur une carte de circuit imprimé équipée de composants au moins deux couches :
- une première couche de matériau organique, relativement épaisse, qui nivelle sensiblement les reliefs et adoucit les angles des composants de façon à faciliter le dépôt de la deuxième couche;
- une deuxième couche d'un matériau minéral présentant de bonnes qualités d'herméticité, qui peut être beaucoup plus fine que la précédente et qui assure l'herméticité de l'ensemble.

Toutefois, le dépôt de deux couches, s'il présente des avantages, fait appel à un certain nombre d'opérations de fabrication distinctes. De plus, les contraintes thermiques conduisent à choisir des matériaux dont le coefficients de dilatation ne soient pas trop éloignés de ceux des matériaux qu'ils recouvrent (circuits imprimés, connexions, composants), ce qui complique le choix des matériaux et, le cas échéant, les processus de fabrication.

La présente invention a pour objet un dispositif de protection hermétique de circuit électronique tel que défini par la revendication 1.

L'invention a également pour objet un procédé de protection hermétique de circuit électronique tel que défini par la revendication 5.

D'autres objets, particularités et résultats de l'invention ressortiront de la description suivante, donnée à titre d'exemple et illustrée par les dessins annexés, qui représentent:
- la figure 1, un mode de réalisation du dispositif selon l'invention ;
- la figure 2, un mode de réalisation du procédé selon l'invention ;
- la figure 3, un mode de réalisation d'un dispositif de mise en oeuvre du procédé selon l'invention ;
- la figure 4, un schéma illustrant les dépôts obtenus dans le procédé selon l'invention.

Sur ces différentes figures, d'une part l'échelle réelle n'a pas été toujours respectée pour la clarté des schémas et, d'autre part, les mêmes références se rapportent aux mêmes éléments.

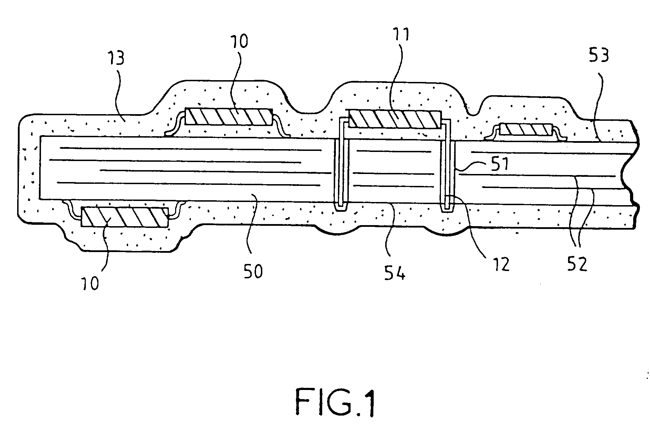

La figure 1 représente donc un mode de réalisation du dispositif de protection selon l'invention.

Dans ce mode de réalisation, des composants électroniques, tels que des pastilles semiconductrices formant des composants discrets ou des circuits intégrés, sont classiquement encapsulés dans les boîtiers mais l'herméticité étant assurée par ailleurs, les boîtiers de composant n'ont pas eux-mêmes à être hermétiques ; on peut ainsi utiliser n'importe quel type de boîtier, par exemple des boîtiers plastiques dont on sait que le coût est très nettement inférieur à celui des boîtiers céramiques qui, eux, ont des qualités d'herméticité. Selon l'invention également, on peut utiliser soit des boîtiers destinés à être montés à plat, de tels boîtiers étant repérés 10 sur la figure 1, soit des boîtiers munis de pattes (ou broches) de connexion, boîtiers repérés 11 sur la figure 1, avec des pattes 12, destinées à traverser la carte de circuit imprimé sur laquelle ils sont montés.

On procède ensuite, classiquement, au montage des boîtiers précédents sur un substrat (ou carte) de circuit imprimé, repéré 50. Selon l'invention et comme précédemment, il est possible d'utiliser n'importe quel type de circuit imprimé, céramique ou époxy, simple couche ou multicouche, simple face ou double face, et dont la taille n'est pas limitée. Sur la figure, on a représenté par exemple une carte multicouche comportant une pluralité de plans de connexion internes, repérés 52, et double face, les composants 10 et/ou 11 étant disposés à la fois sur la face supérieure (53) et sur la face inférieure (54) de la carte 50. En outre, le substrat de circuit imprimé 50 comporte des trous métallisés 51 pour ceux des boîtiers (11) qui comportent des pattes de connexion (12).

Selon l'invention, on dépose ensuite sur sensiblement l'ensemble du circuit imprimé 50 et des boîtiers 10 et 11, une couche 13 dont la composition est variable. Cette couche 13 est constituée d'un matériau organique électriquement isolant du côté du circuit imprimé 50; la composition varie avec l'épaisseur de la couche pour donner une densité de plus en plus élevée, formant ainsi une pellicule hermétique. Cette variation de composition conduit à des densités variant progressivement de 1 à 1,5 par exemple.

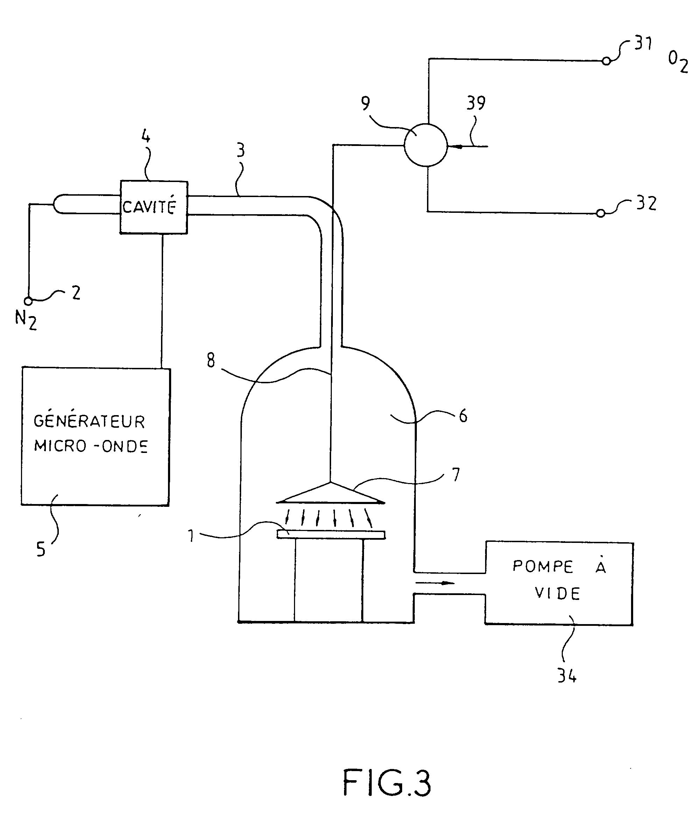

Selon une méthode préférée, cette couche 13 est déposée par polymérisation d'éléments issus de la dissociation d'un gaz par plasma différé d'azote. Un tel dépôt peut être réalisé à l'aide d'un dispositif tel que représenté figure 3.

La figure 3 est un schéma de principe du dispositif décrit dans la demande de brevet français n° 93.14519, au nom de LCC, dans lequel est placé le circuit imprimé équipé de ses composants, globalement repéré 1.

Le réacteur 6 est alimenté d'une part par un plasma d'azote et d'autre part par des espèces réactives. Une pompe à vide 34 assure l'écoulement des gaz.

Le plasma utilisé est un plasma froid différé (ou post-décharge) en écoulement. Comme cela est connu de l'homme du métier, un plasma froid différé en écoulement est obtenu sous une pression de quelques hPa, par extraction et détente dans un réacteur, en dehors du champ électrique, des espèces actives formées dans un plasma en décharge. Les plasma d'azote en post-décharge ne contiennent donc pas d'électrons ou d'ions en quantité significative. Leurs espèces réactives sont des atomes, des radicaux libres ou des espèces moléculaires excitées ; il est donc préférable de choisir un corps pour former le plasma qui se caractérise par des espèces réactives de longue durée de relaxation. Par ailleurs, on sait qu'un plasma de post-décharge permet d'obtenir, à relativement basse température, des actions physico-chimiques normalement atteintes à des températures très élevées. Dans ce cadre, le plasma différé d'azote convient particulièrement bien.

Dans le cas présent, une source 2 d'alimentation d'azote est envoyée dans une cavité micro-onde 4, par l'intermédiaire d'un tube 3. La pression de l'azote à l'intérieur du tube 3 est comprise entre 1 et 20 hPa. Sous l'effet de l'onde engendrée par un générateur micro-onde 5, magnétron par exemple, une décharge est entretenue dans la cavité 4. La fréquence de l'onde issue du générateur micro-onde 5 est, par exemple, égale à 2450 Mhz, à 433 Mhz, ou à 915 Mhz. L'azote se trouve excité en sortie de la cavité. Le pourcentage d'azote dissocié est alors préférentiellement compris entre 0,5 et 3 pour cent.

Les espèces réactives (sources 31 et 32) sont introduites dans le réacteur par un conduit 8, schématisé par un simple trait, vers un dispositif évasé 7 disposé immédiatement au-dessus du circuit équipé 1, permettant de répartir les espèces réactives sur la surface du circuit 1. La source 31 fournit de l'oxygène alors que la source 32 fournit un gaz dit précurseur, organo-silicé ou organo-germané. Les gaz peuvent être mélangés dans un mélangeur 9 avant d'être introduits dans le réacteur 6, ou bien mélangés par introduction de l'un dans le flux de l'autre. La commande de la proportion de gaz précurseur par rapport à l'oxygène est symbolisée, à titre d'exemple, par une flèche 39 sur le mélangeur 9, les ratios des flux pouvant être gérés par des régulateurs de débits massiques.

Selon l'invention, on commence par déposer, sur le circuit équipé 1, un matériau par exemple de densité faible par dissociation du gaz précurseur par le plasma, puis, en faisant varier la proportion d'oxygène (continûment ou par paliers), on modifie la composition du matériau déposé jusqu'à obtenir une couche de plus forte densité à la fin du processus.

Selon une variante préférée de l'invention, on fait varier la proportion d'oxygène par paliers, de sorte à obtenir pour la couche 13 une structure du type sandwich, comportant alternativement une couche de matériau peu dense et une couche de matériau plus dense, les couches étant à composition sensiblement constante et la variation de composition se faisant à la transition entre les couches. A titre d'exemple, on peut réaliser ainsi de deux à dix couches successives sur le circuit imprimé, la couche située du côté du circuit étant plus ou moins dense mais impérativement électriquement isolante.

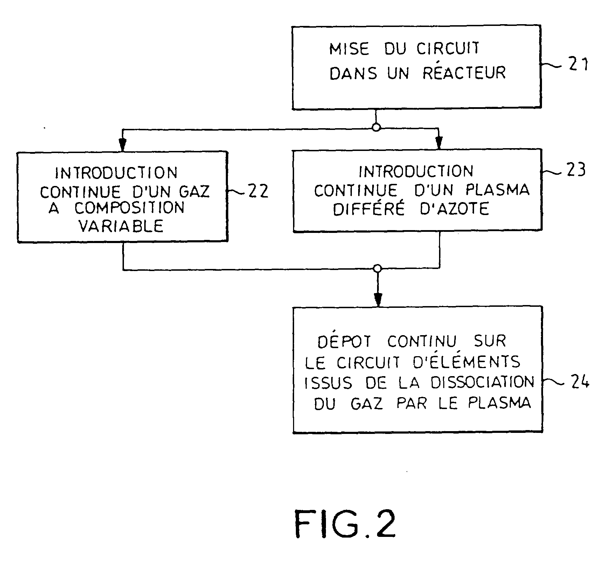

La figure 2 résume le procédé selon l'invention.

Dans une première étape 21, le circuit imprimé équipé de ses composants est disposé dans le réacteur (6, figure 3).

Dans le réacteur est introduit en continu, d'une part, un gaz précurseur à composition variable (étape 22) et, d'autre part, un plasma différé d'azote (étape 23).

Il résulte un dépôt sur le circuit d'éléments issus de la dissociation du gaz précurseur par le plasma (étape 24).

A titre d'exemple, le gaz précurseur peut être un composé organo-silicé tel que :
- un alkoxysilane de formule : 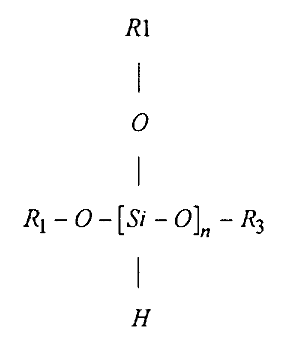 avec n inférieur ou égal à 5;
- un siloxane de formule : 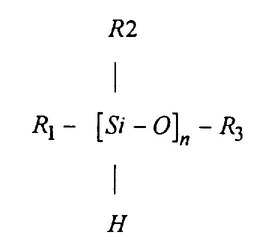 avec n inférieur ou égal à 4;
- un silazane de formule : 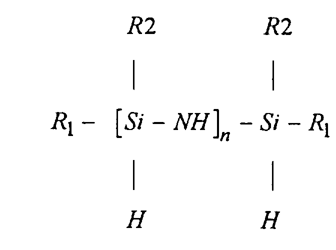 avec n inférieur à 4;

Plus généralement, tous les composés organo-silicés conviennent, à condition qu'ils comportent une fonction silane (radical terminal Si-H).

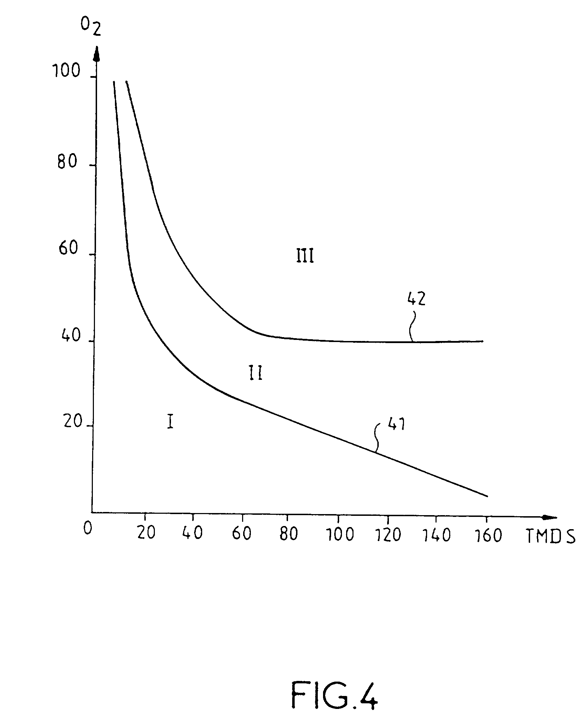

La figure 4 illustre, par exemple pour un siloxane, la variation de la densité du dépôt en fonction de la proportion d'oxygène.

Sur le graphe de la figure 4, on a porté en abscisse le flux de TétraMéthylDiSiloxane (TMDS), exprimé en cm³ par minute (SCCM) et en ordonnée, le flux d'oxygène (O₂) exprimé dans la même unité. On a représenté deux courbes, 41 et 42, rappelant la forme d'un "L", délimitant trois régions, notées I, Il et III de l'origine O vers les valeurs élevées d'abscisse et d'ordonnée.

Dans la région I, correspondant soit à des flux O₂ et TMDS sensiblement équilibrés mais relativement faibles, soit à un flux O₂ ou TMDS important pour un flux faible de l'autre corps, on obtient des dépôts de matériaux à forte réticulation.

Dans la région III, correspondant à des flux O₂ ou TMDS élevés, on obtient des dépôts de matériaux à réticulation plus faible.

La région II, comprise entre les courbes 41 et 42, est une région intermédiaire.

La protection selon l'invention, telle que décrite ci-dessus, présente un certain nombre d'avantages, parmi lesquels on peut citer :
- l'adaptation progressive des réseaux cristallographiques à l'intérieur de la couche 13, ce qui permet de minimiser les contraintes thermomécaniques et donc les risques de fissures, et donc garantit une meilleure herméticité ; cet aspect est renforcé dans le cas où la couche 13 a une structure du type sandwich ;
- une absence de dégazage, grâce à l'utilisation d'un procédé sous vide et à l'absence de radicaux non-réagis qui sont susceptibles d'être piégés lorsque le dépôt est réalisé par bombardement du circuit par des espèces énergétiques ;
- une haute tenue en température du fait des conditions de dépôt des matériaux (polymères silicés réticulés).

ll apparaît ainsi que l'invention permet notamment de réaliser l'herméticité des deux faces de n'importe quel circuit monté sur un circuit imprimé, sans nécessiter de modification de celui-ci, d'implantation ou de matériau notamment. Elle permet également une réparation locale sans destruction de l'herméticité du reste du circuit porté par la carte, le ou les composants de remplacement pouvant être également rendus hermétiques par la même méthode. En outre, les couches ainsi déposées étant peu épaisses par rapport à l'épaisseur du circuit lui-même, elles ne forment pas un obstacle à l'évacuation de la chaleur engendrée par le fonctionnement des composants. Enfin, ces différentes couches étant transparentes sous faible épaisseur, les marquages des circuits sont visibles à travers les couches et il n'est pas nécessaire de les reproduire sur la couche extérieure.

Enfin, par rapport aux procédé et dispositif décrits ci-dessus, un certain nombre de variantes sont possibles. Par exemple, il est possible d'opérer, après l'étape 21 de la figure 2, d'abord l'introduction du plasma différé d'azote (étape 23) seul, sans gaz précurseur, de façon à réaliser un pré-traitement destiné à favoriser l'adhésion des couches ultérieures sur le circuit imprimé. ll est également possible de réaliser, après l'obtention de la couche 13, le dépôt d'une couche métallique faisant notamment fonction de blindage électromagnétique ; un tel dépôt peut être réalisé comme celui de la couche 13, par dissociation d'un gaz par le plasma différé d'azote, le gaz étant alors un complexe métallique.

## Revendications

1. Dispositif de protection hermétique de circuits électroniques, comportant des boîtiers enfermant chacun des circuits électroniques et une carte de circuit imprimé sur laquelle sont montés les boîtiers, le dispositif étant caractérisé par le fait qu'il comporte en outre une couche recouvrant sensiblement l'ensemble de la carte et des boîtiers, la composition de la couche variant selon son épaisseur de sorte à former au moins un matériau de faible densité et un matériau de densité plus forte, ce dernier formant une pellicule hermétique, le matériau disposé du côté du circuit imprimé étant électriquement isolant.

2. Dispositif selon la revendication 1, caractérisé par le fait que la couche est du type sandwich et comporte alternativement une épaisseur de matériau de forte densité et une épaisseur de matériau de plus faible densité.

3. Dispositif selon l'une des revendications précédentes, caractérisé par le fait que la couche est obtenue par dissociation d'un même gaz précurseur, en présence d'une proportion variable d'oxygène, par un plasma froid différé d'azote.

4. Dispositif selon l'une des revendications précédentes, caractérisé par le fait qu'il comporte de plus, déposée sur ladite couche, une couche supplémentaire métallique formant blindage électromagnétique.

5. Procédé de protection hermétique de circuit électronique, caractérisé par le fait qu'il comporte les étapes suivantes :
- une première étape de montage d'au moins un boîtier, encapsulant le circuit électronique, sur une carte de circuit imprimé ;
- une deuxième étape d'introduction, dans un réacteur, d'un plasma différé d'azote au-dessus du circuit imprimé ;
- une troisième étape, simultanée à la deuxième étape, d'introduction dans le réacteur, au-dessus du circuit imprimé, d'un gaz dit précurseur, comportant un composé organo-silicé ou organo-germané, et d'oxygène, dont les proportions varient dans le temps ;
- le dépôt sur le circuit imprimé d'éléments organo-silicés ou organo-germanés, issus de la dissociation de gaz par le plasma, selon lesdites proportions, ces dernières variant de sorte à obtenir au moins une épaisseur de dépôt hermétique.

6. Procédé selon la revendication 5, caractérisé par le fait qu'il comporte de plus, avant la deuxième étape, une étape de pré-traitement permettant de favoriser l'adhésion des couches ultérieures.

7. Procédé selon la revendication 6, caractérisé par le fait que l'étape de pré-traitement consiste à introduire, dans le réacteur le plasma différé d'azote seul.

8. Procédé selon la revendication 5, caractérisé par le fait qu'il comporte, après les étapes précédentes, une étape supplémentaire de dépôt d'une couche métallique.

9. Procédé selon l'une des revendications 5 à 7, caractérisé par le fait que le gaz précurseur est un composé organo-silicé ou organo-germané.

10. Procédé selon la revendication 9, caractérisé par le fait que le gaz précurseur est un alkoxysilane, un siloxane ou un silazane.
